# EUROPEAN PATENT SPECIFICATION

(11) **EP 0 381 332 B1**
(45) Date of publication and mention of the grant of the patent: **05.11.1997**
(21) Application number: 90300469.5
(22) Date of filing: 17.01.1990
(51) Int. Cl.: G06F 17/50

(54) **Improvements in or relating to the simulation of circuits having analogue parts and digital parts**
Simulation von Schaltungen mit Analogteilen und Digitalteilen
Simulation de circuits ayant des parties analogiques et des parties numériques

(30) Priority: 03.02.1989 GB 8902464
(43) Date of publication of application: 08.08.1990
(73) Proprietor: TEXAS INSTRUMENTS INCORPORATED, Dallas Texas 75265 (US); TEXAS INSTRUMENTS LIMITED, Bedford MK41 7PA (GB)
(72) Inventor: Rumsey, Michael M., Clapham Bedford MK 41 6BG (GB); Sackett, John W., Bedford MK 41 (GB)
(74) Representative: Abbott, David John

(56) References cited:
- EP-A- 0 296 812
- IBM TECHNICAL DISCLOSURE BULLETIN, vol. 31, no. 7, December 1988, pages 170- 173, Armonk, NY, US; "Simulation technique for analog functions in a mixed analog and digital semiconductor chip design environment"
- IBM TECHNICAL DISCLOSURE BULLETIN, vol, 30, no. 11, April 1988, page 450, Armonk, NY, US; "Method for mixed-mode simulation in a hardware logic symulator"
- 7TH INTERNATIONAL CONFERENCE ON CUSTOM AND SEMI-CUSTOM ICS, London, GB, 1987, pages 49.1 - 49.10; M. RUMSEY: "Behavioral modelling of mixed analog-digital circuits"
- VLSI SYSTEMS DESIGN, January 1988, pages 16,17,20,21,24,25; B. O'ROURKE: "Behavioral modelling of digital devices in an analog simulation environment"

## Description

The present invention relates to the simulation of the operation of a circuit having both analogue circuit parts and digital circuit parts connected together.

When designing an electronic circuit it is common practice to simulate the operation of the circuit using a suitable computer program in order to ensure that the circuit when constructed will perform the required functions. At the highest level of the construction hierarchy of an electronic system are sub-systems, below which are functional building blocks, and finally at the lowest level there are individual components such as transistors, resistors and capacitors.

It is not practical to provide a simulator based on sub-systems because of the wide variety of sub-systems which could be used.

Simulators which simulate systems through analysis of the currents and voltages in the lowest level components are termed "circuit level" simulators. Although such simulators are usually quite accurate and can simulate both analogue and digital circuit blocks, they operate very slowly so that a long period of time is required to obtain a full simulation of the behaviour of the overall system.

Another kind of simulator operates by utilising the behavioural descriptions of the functional building blocks, such as for example logic gates, operational amplifiers, filters, etc. When such a simulator is used to simulate the operation of digital circuits it is known as a "logic simulator" and uses digital logic values as the signals to provide the interaction between the blocks. Logic simulators cannot simulate the operation of analogue circuits because of the continuously variable nature of the signals to be fed from one circuit block to another. On the other hand, logic simulators can simulate the operation of digital circuits quite quickly and can readily be programmed to provide a reasonable simulation of a digital system in a relatively short period of time.

An article entitled "Behavioral modeling of digital devices in an analog simulation environment" (VLSI Systems Design: January 1988: pages 16, 17, 20, 21, 24, 25: Author - B. O'Rourke) discusses the modelling of the analog behaviour of circuits or systems that include clocked digital devices and is directed principally at the use of general descriptions of device and system functions that are independent of the implementation technology.

An article entitled "Behavioural modelling of mixed analog-digital circuits" (Proceedings of the 7th International Conference on custom and semi-custom ICs held in London: 1987: pages 49.1 to 49.10: Author - M. Rumsey) discusses the simulation of mixed analog-digital integrated circuits by the use of a behavioural approach in contrast to direct transistor-level analysis as a method of achieving system-level simulation of a silicon chip during design development.

There are two common types of logic simulators; event-driven and levelised compiled code simulators. In an event-driven logic simulator, the response of a circuit is only evaluated when its inputs are changed, and the simulator must employ an event queue in order to maintain the changes at different parts of the circuit in step. The servicing of the event queue requires a lot of processing to be done by the computer, and consequently slows down the operation of the simulator. In a levelised compiled code logic simulator, the inputs to a circuit are set up and maintained at those values while each logic element is evaluated in the order of signal flow through the circuit. The sequential nature of the analysis makes evaluation much simpler and therefore faster than in the case of an event-driven simulator.

Enhancements of event-driven logic simulators have been proposed to enable them to cope with analogue circuit blocks and these have relied upon the use of real numbers indicating the actual values of voltage signals at sampling instants in the operation of both analogue and digital circuits. Such enhancements of logic simulators tend to slow down their operation so that a longer period of time is required to simulate the operation of digital circuits than is possible when only digital logic values are transmitted between the blocks.

It is an object of the present invention to enable the simulation of the operation of circuits composed of analogue circuit blocks in which the disadvantages outlined above are substantially overcome.

The invention provides a method of simulating the operation of a circuit comprising a plurality of analog circuit blocks having operational parameters by means of digital computer, said method comprising:
representing the circuit having a plurality of analog circuit blocks by a computer program;
in the computer program, representing each of said plurality of analog circuit blocks by a procedure call;
in the representation of each analog circuit block by a procedure call, including details of input signal names and values, and output signal names and values, the operational parameters of the analog block, and the sampling instant for evaluation of each output signal value;
representing each connection between the analog circuit blocks by the use of the same signal name for an output signal and an input signal;
providing real numbers to indicate the actual values of the input and output signals;
establishing each sampling instant for the evaluation of an output signal value as the time at which that value has changed by a predetermined amount since the previous sampling instant, or an earlier time at which the value of another output signal of the same analog signal block has changed by the predetermined amount;
selecting a sampling time common to all of the procedure calls as the earliest of the sampling instants provided by the procedure calls of all of the analog circuit blocks included in the circuit whose operation is being simulated; and
evaluating the output signal values from the procedure calls representing each of said plurality of analog circuit blocks at the selected sampling time common to all of the procedure calls.

Preferably, the method includes modelling the operation of a circuit comprising digital circuit blocks by a logic simulator of an event-driven type in a manner known per se so as to provide a model of a circuit including an analog sub-system and a digital sub-system;
representing the interconnections between the analog sub-system and the digital sub-system by an analog/digital interface; and
arranging the time scale of the digital sub-system to match the time scale of the analog sub-system.

Alternatively, the method includes modelling the operation of a circuit comprising digital circuit blocks by a logic simulator of a levelised compiled code type in a manner known per se so as to provide a model of a circuit including an analog sub-system and a digital sub-system;
representing the interconnections between the analog sub-system and the digital sub-system by an analog/digital interface; and
arranging the time scale of the digital sub-system to match the time scale of the analog sub-system.

Preferably, the method includes at least one one-bit digital-to-analog conversion in response to a digital logic value from the digital sub-system; and/or
at least one one-bit analog-to-digital conversion in response to an analog signal value from the analog sub-system.

Preferably, the circuit comprises a plurality of analog circuit blocks including a feedback path in which an input signal to part of the circuit is derived from an output signal of that part, and the method includes progressively adjusting the fedback input signal conditioned upon previous adjustments of the fedback input signal while external input signals to the circuit are held constant; and
repeating the adjustments to the fedback input signal until a stable fedback input signal and a stable output signal are obtained.

Preferably, the method includes deriving an estimated value for the fedback input signal from the input signals applied to the circuit part before each of the progressive adjustments to the fedback input signal and terminating the process of progressive adjustments to the fedback input signal when the difference between the value of the fedback input signal and the estimated value is less than a predetermined amount.

Preferably, the predetermined amount is a predetermined fraction of a previous voltage step allocated to the circuit block.

Preferably, the method includes storing the values of the internal states of the part of the circuit to which the fedback input signal is applied in duplicate as a master copy and a working copy;
copying the working copy from the master copy at each adjustment of the fedback input signal;employing the working copy in calculating the output signal value of the circuit part; and
updating the master copy at the common sampling times.

Preferably, the method includes deriving the estimated value for the fedback input signal from the input signals applied to the circuit part by a first manner of derivation wherein small changes in the input signals are caused to occur;
measuring the resulting changes in the fedback input signal;
calculating a sensitivity factor relating the resulting changes to the causal changes; and
deriving the estimated value for the fedback input signal from the input signals by employing the sensitivity factor on the assumption that the relationship is purely linear.

Preferably, the method includes monitoring the adjustments of the fedback input signal;
determining whether the condition for terminating the progressive adjustments to the fedback input signal may be satisfied within a few further additional adjustments; and
changing to a second manner of deriving the estimated value for the fedback input signal based upon the difference between the value of the fedback input signal and the previous estimated value when the condition for terminating the progressive adjustments to the fedback input signal is not satisfied within the few further additional adjustments.

Preferably, the second manner of deriving the estimated value for the fedback input signal involves moving the estimated value toward the obtained value of the fedback input signal in increasing jumps until an overshoot occurs; and
reducing the jumps in response to the occurrence of an overshoot to a fraction of the previous size and performed in the opposite direction.

Preferably, the predetermined amount is 1 % of the maximum possible variation in the output signal.

The analogue sub-system model may be a levelised compiled code model. Because the signals occurring in analogue are continuous functions of time and the digital computer requires numbers to process, it is necessary to sample the analogue signals at discrete time points and process the values obtained. In a procedure call modelling an analogue electrical circuit block the sampling instants are to be set when by the change in an output signal of the block since the previous sampling instant is a predetermined voltage or current step. An example of a voltage step would be 1% of the maximum possible variation in the output signal voltage. Such a procedure for setting the sampling instant when applied to all the analogue circuit blocks in the sub-system could give rise to several different sampling instants. Because the model of the analogue sub-system is of the levelised compiled code type it is necessary to use the same sampling instants in all the analogue circuit blocks in the sub-system and this is achieved by each time selecting the earliest sampling instant among all the analogue circuit blocks in the sub-system and using that instant in all the analogue circuit blocks. In that way the accuracy of the analogue simulation is at least as good as that set by the user when he defined the voltage steps. In addition, the value of the output voltage of the block(s) at the sampling instant must be represented by a number which can be transmitted to the next block(s) in the circuit. Of course, the time scale in the analogue circuit sub-system model will not, in general, correspond to real time but it must match the time scale used in the logic simulator for the digital circuit blocks.

The analogue circuit sub-system may include a feedback path so that an input to part of the circuit is derived from an output of that part. The levelised compiled code simulation of the analogue sub-system may be arranged to model the operation of the feedback path. The response of the circuit may be determined by a process of progressive adjustments of the fed back input resulting from taking into account the previous adjustment of that input, whilst any external inputs to the circuit are held constant. The adjustment is repeated a number of times until a stable fed back input and a stable output are obtained. While the adjustments are being calculated the signal values in parts outside the feedback loop, both analogue and digital, do not change. Two or more unconnected feedback circuits can be processed at the same time.

Examples of the simulation of the operation of circuits will now be described with reference to the accompanying drawings, of which:-
Figure 1 is a block diagram of a circuit having analogue and digital parts;
Figure 2 is a block diagram of an example of a digital circuit;
Figure 3 is a block diagram of an example of an analogue circuit; and
Figure 4 is a block diagram of an example of an analogue circuit including feedback.

Let it be supposed that it is required to simulate the operation of a circuit including both an analogue part and a digital part. The design of the circuit is entered into a computer in the form of cells respectively representing the functional blocks, both analogue and digital, of the circuit. Each cell contains the name or source of the, or each, input signal to the particular block, the name or destination of the, or each, output signal from the particular block, and some representation of the signal processing properties of the particular block from which the value of the output signal(s) generated by the block in response to the input signal(s) can be derived.

When the model is operated, the externally originating signals which form the inputs, analogue and/or digital, to the circuit are set to the required initial values, and are then changed in the same way as they would in the operation of the circuit itself. The input signals to the digital part of the circuit have digital logic values, such as "high" and "low" or "0" and "1". An input signal to the analogue part of the circuit are samples taken from a continuous signal which is a continuous function of time at given sampling instants. The changes in the two types of input signal, analogue and digital, must be kept in synchronism and may take place at a slower rate than real time to allow time for the model of the circuit to respond to the changes. On the other hand, if the processing speed of the computer is high enough or the digit rate of the digital input signals and the frequency content of the analogue input signals are low enough, the model may operate on samples in real time.

The procedure calls representing blocks receiving the input signals from outside the circuit are processed by the computer to determine what output signals they will produce, and the resulting signals are applied as inputs to other procedure calls. The signals received by these other procedure calls are processed, resulting in other signals being generated and applied to further procedure calls, and so on. The processing of the procedure calls follows the various signal paths through the circuit with the final result that one or more output signals are generated. The computer is arranged to display the output signals to the user as the response of the model of the circuit to the input signals. The computer may also display the values of the intermediate signals to aid the understanding of the operation of the circuit model. Facilities may be provided for changing the parameters of some procedure calls representing circuit blocks so that the user can see the effect of changing component values or performance characteristics on the operation of the circuit.

The simulation program of the computer is divided into two distinct parts, a first part providing a model of the digital blocks in the circuit and a second part providing a model of the analogue blocks in the circuit. The first part of the program, that providing the model of the digital blocks in the circuit, is a conventional logic simulator program. The second part of the program, that providing the model of the analogue blocks in the circuit, not only handles the transmission of the signals between the analogue blocks but it also provides the conversion of the analogue signal values to digital logic values for signals which are applied to a digital block from an analogue block, and the conversion of digital logic values to analogue signal values for signals which are received by an analogue block from a digital block. Typically, the analogue to digital conversion will involve the production of a "1" if the analogue voltage is above a threshold value and the production of a "0" if it is below that value. The digital to analogue conversion may result in a first voltage (say, 5 volts) being produced in response to a "1" and a second voltage (say, 0 volts) being produced in response to a "0".

Although the input and output signals of the analogue circuit blocks are usually measured in terms of voltage, there are forms of analogue circuit system component where some other electrical or mechanical variable forms the input and/or output signal, such other forms of component can also be modelled by the procedure calls.

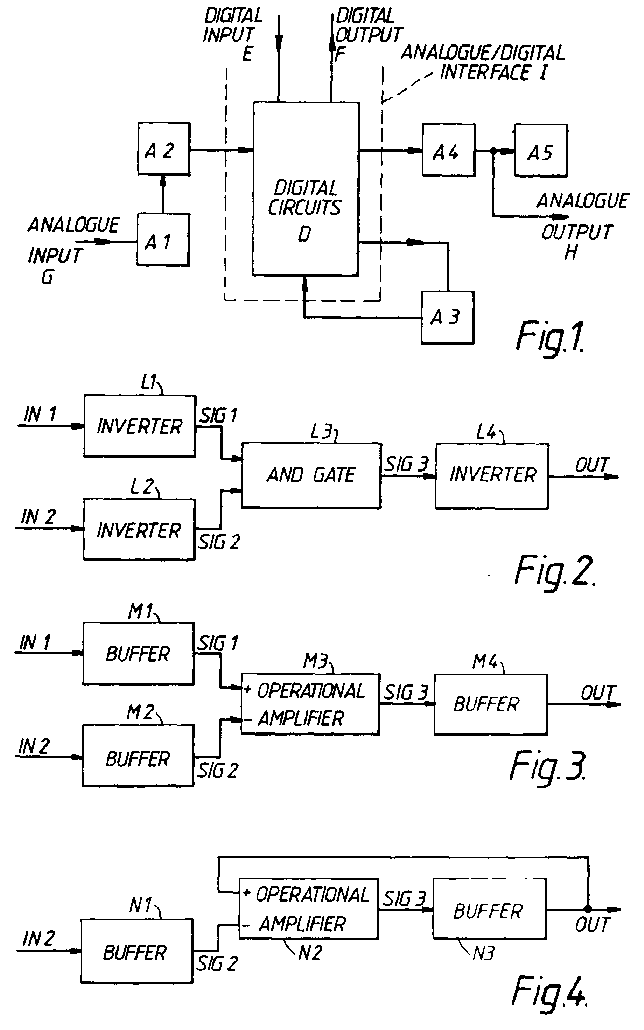

Referring now to Figure 1 which shows a hypothetical circuit having digital circuits D and analogue circuit blocks A1, A2, A3, A4 and A5. The blocks A2 and A3 are connected to apply input signals to the digital circuits D, and the blocks A3 and A4 are connected to receive input signals from the digital circuits D. The analogue/digital interface is represented by the broken line I; this interface represents the conversion of analogue signals to digital logic signals for signals which are being applied to the digital circuits D from the analogue blocks A1 - A5, and the conversion of digital logic signals to analogue signals for signals received by the analogue blocks A1 - A5 from the digital circuits D. Digital logic input signals from an external source are applied to the digital circuits D along an input E. Digital logic output signals from the digital circuits D are applied to an external circuit along an output F. Analogue signals in the form of sampled values are applied as inputs to the analogue block A1 along an input G. Analogue output signals from the analogue block A4 appear on an output H, again in the form of sampled values.

When simulating the operation of the circuit shown in Figure 1, the first part of the program, the logic simulator, provides a model of the digital circuits D and the second part of the program provides a model of the analogue circuit blocks A1, ..., A5 as well as the analogue/digital interface I.

Of course, the program is not limited to simulating the operation of the circuit shown in Figure 1, but can simulate the operation of any circuit.

An advantage of separating the analogue circuit blocks from the digital ones in the simulation by providing separate simulation programs for the analogue part and the digital part of the circuit is that is necessary to transmit analogue signal values only in the analogue part, because the digital part need transmit only digital logic values.

Figure 2 shows an example of a digital circuit having two inverters L1 and L2 to which input signals IN1 and IN2 are respectively applied. The outputs of the inverters L1 and L2 which are SIG1 and SIG2 respectively are applied to the inputs of an AND-gate L3. A further inverter L4 receives the output SIG3 and the AND-gate L3 to produce the output signal.

The input to the computer by the user specifies the circuit shown in Figure 2 in terms of hardware description language as follows:-

| Name | Block type | input/output signals |
|---|---|---|
| L1: | Inverter | IN1, SIG1; |
| L2: | Inverter | IN2, SIG2; |
| L3: | AND-gate | SIG1, SIG2, SIG3; |
| L4: | Inverter | SIG3, OUT. |

In the program constructed by a levelised compiled code logic simulator the four procedure calls representing the four logical elements L1, L2, L3 and L4 are set out as follows:-

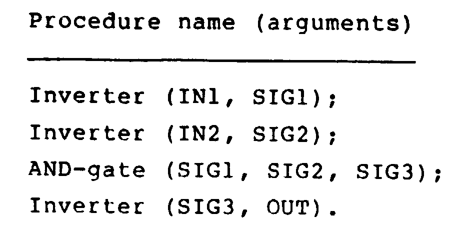

The logic simulator includes a library of logic elements including an inverter and an AND-gate and the information in the library includes the fact that an inverter has one input signal and one output signal, and the fact that an AND-gate has two input signals and one output signal.

It should be noted that the order of the procedure calls in the program is critical because the statements are executed sequentially and it is necessary for the values of SIG1 and SIG2 to be worked out before the output SIG3 of the AND-gate is derived from the values of SIG1 and SIG2. As mentioned above, the signals IN1, IN2, SIG1, SIG2, SIG3 and OUT can assume only logic values such as 0 and 1 or high and low.

Figure 3 shows an example of an analogue circuit having buffers M1 and M2 to which input signals IN1 and IN2 are respectively applied. The outputs of the buffers M1, M2, which are named SIG1 and SIG2, are applied to the noninverting and inverting inputs respectively of an operational amplifier M3. The output signal of the operational amplifier M3 is named SIG3 and is applied through a buffer M4 to produce the output signal OUT.

In simulating the operation of this analoque circuit the user would employ the second part of the program which would draw from a library of primitive circuits storing the different forms of analogue circuit block, the procedure call forms for the four circuit elements M1, M2, M3 and M4. The circuit shown in Figure 3 may be specified as follows:-

| Name | Block type | input/output signals |
|---|---|---|
| M1 | Buffer | IN1, SIG1; |
| M2 | Buffer | IN2, SIG2; |
| M3 | OPAMP | SIG1, SIG2, SIG3; |
| M4 | Buffer | SIG3, OUT. |

Because the circuit elements in this instance are for handling analogue signals and not digital ones, the library records the parameters that determine the performance of the circuit elements. In addition it is necessary for the program to provide a mechanism for handling circuit evaluation times. In the case of an event-driven model of a digital circuit the signals in the model are evaluated whenever one of the inputs of the circuit changes, this being possible because the change from one state to another of the input and output signals is assumed to be instantaneous. For an analogue circuit model the program must determine the times of evaluation of the input and output signals because the values of these signals can be varying all the time and it is possible for an output value of a circuit to be varying even though the inputs to that circuit are constant.

The program determines the evaluation times by reference to a voltage step. This voltage step is an increment or decrement in the voltage concerned and may be an absolute value, such as, for example, 1 millivolt. The program provides an opportunity for the user to define a voltage step appropriate to each analogue circuit element. The program calculates the future time, relative to the present time at which the specified voltage step will be reached in the output value of the circuit on the basis of the parameters specified for that circuit in the library. The future times for all of the circuit elements in the circuit are then compared and the earliest of these is selected by the program for use by all the circuit elements in the circuit. The interval between the present and future times is termed the "retrigger time" and can vary throughout the period of operation of the circuit. At the start of the program the value of the retrigger time is initially set at an arbitrarily high level, but after the program has worked through all of the circuit elements the retrigger time will have the value required by the element having the tightest timing requirement.

The resulting program structure for the circuit shown in Figure 3 is as follows:-

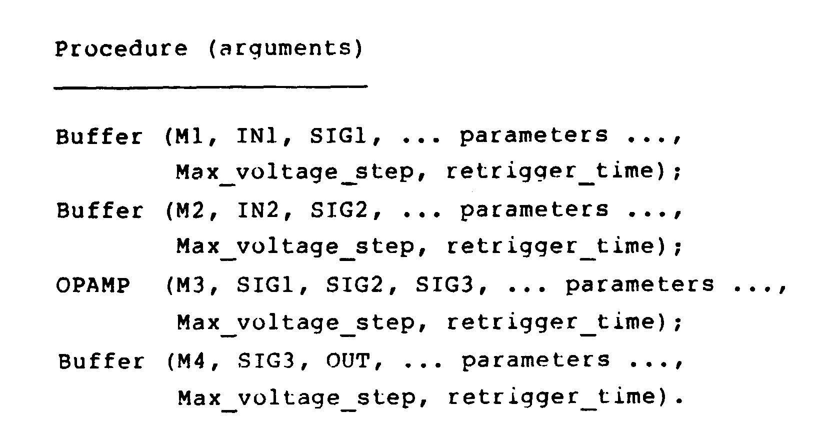

Comparison of that program structure with the structure produced for the digital circuit reveals the following differences. Each cell includes the reference number - M1, M2, etc., of the circuit element which is used as a pointer to memory locations where previous state values may be recorded for use in the modelling algorithms. The circuit parameters are not required for digital devices because the logical operation performed by any such device is determined by its name. In the case of analogue circuit elements there could, for example, be operational amplifiers having different gains and different slew rates. A third difference is in the provision of the maximum voltage step and the retriggering time which are used as described above.

In addition to evaluating the outputs of the models at the instants determined by the retriggering time, the model is also evaluated when an input to the analogue circuit as a whole is changed, for example, in response to a change in a digital logic signal applied to the analogue sub-system. This means that each model of a circuit element must have the ability to evaluate its output at any time and not simply at the specified voltage steps.

As mentioned above, it is necessary to keep the changes in the analogue part of the circuit in step with those in the digital part, which involves maintaining the correct relationship between the retriggering times and the clock times of the digital circuits.

At the interfaces between the analogue circuits and the digital circuits, the program inserts one-bit analogue-to-digital converters or digital-to-analogue converters for carrying out the conversion between digital logic values and analogue signal values.

Analogue circuits, and hence the models representing them, sometimes contain feedback where the output of a block in a circuit is fed back to its own input or that of an earlier block in the circuit. In this situation it is impossible to work through the circuit from input to output to determine the signal levels at each block, but if the feedback loop is broken, it can be done, although there will remain a feedback signal which must be taken into account.

Figure 4 shows an example of a circuit with feedback. An input signal IN2 is applied as an input to a buffer N1, the output, SIG2, of which is applied to the non-inverting input of an operational amplifier N2. The output signal, SIG3, of the amplifier N2 is applied as the input to a buffer N3 the output of which forms the output signal OUT of the circuit. The signal OUT is also fed back to be applied to the inverting input of the amplifier N2.

The model program compiled by the simulators follows the principles outlined above with reference to Figure 3 except that it contains a loop for calculating the feedback signal. The program to model that circuit is as follows;-

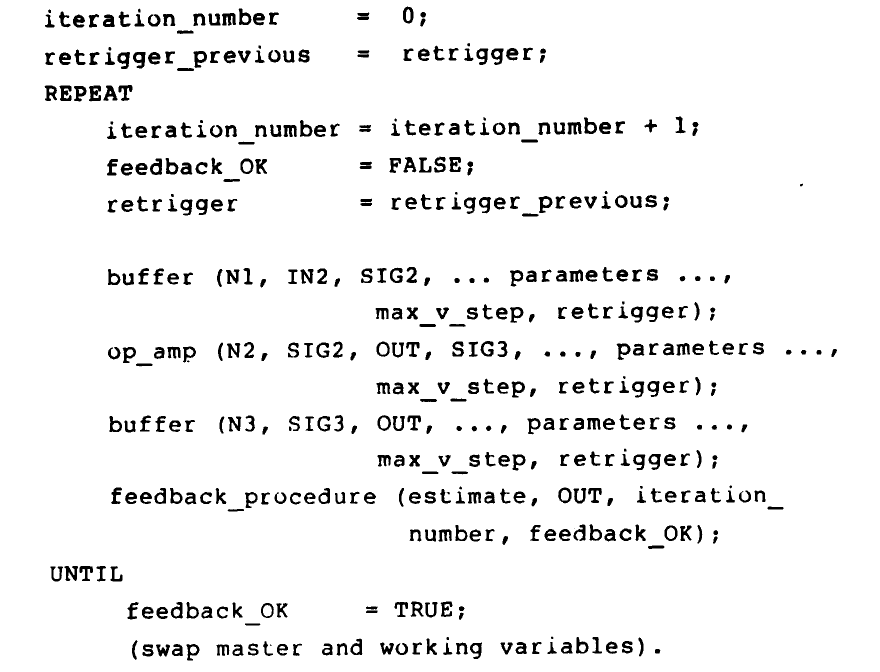

The second program provides a method of feedback management which may be summarised as follows. First some terminology will be clarified. The model is invoked at various instants, and following each instant a number of iterations round the feedback loop(s) are made to establish the correct value of the feedback signal(s). It is in this context that the terms "iteration" and "invocation" are used in the following description.

The program includes a procedure which is applied to a signal that is fed back. At each invocation this procedure estimates the value that the feedback signal should have at that instant. Several iterations are made of a program loop for evaluating the feedback signal. The iterations are terminated when the difference between the value of the feedback signal and an estimated value derived from previous values of the feedback signal becomes sufficiently small, for example, a predetermined fraction of the voltage step allocated to the circuit block.

Some circuit blocks require a memory of past state information, and these actually have two copies of that information. One is known as the master copy, and the other as the working copy. Upon each iteration the master copy of the past state information is copied into the working copy of the past state information, and it is the working copy that is used to calculate the model output. This procedure is followed so that each iteration within an invocation is calculated on the basis of correct past information - if this were not done then each iteration would update the past state information, which is required to be the past state at the previous retrigger time and therefore must be fixed until the next retrigger time. Once the last iteration is made the working copy of the information is what should be the master copy for the next retrigger time and so, after each invocation of the model, the pointers indicating the working and master copies are swapped over.

The two features mentioned above, the production of an estimate of the feedback signal and the use of working and master copies of the past state information, make possible the evaluation of feedback signals. There are two key elements in the first feature. First it is necessary to establish when the value of the feedback signal is sufficiently stable, and secondly when it is necessary to make a new calculation of the estimated value. These processes are performed as follows.

On the first iteration within an invocation the initial value used for the feedback signal is actually the value of that signal generated on the previous invocation. As that value was generated at an earlier time instant it is not correct for the present time instant. The output signals of the circuit blocks are evaluated and then the procedure for estimating the value of the feedback signal is called and the difference between the estimated value and the obtained value is measured. This difference is recorded as a criterion as to whether or not the feedback signal estimate is good enough; if the difference between estimated value and the obtained value on a subsequent iteration is smaller than a given fraction of the first difference (e.g. by a factor of 20), then the estimate is deemed good enough. The first difference is dependent on the voltage step size of the immediately preceding block, and what is required is to make sure that the error in estimating the feedback value is small relative to that voltage step size.

Upon completion of the first iteration the procedure for estimating the value of the feedback signal will modify that value in preparation for the second iteration. The latest estimated value is a small fraction of the way from the last estimated value towards the last obtained value. In a stable system, moving the estimated value towards the obtained value will always cause the next obtained value to move in the direction towards the estimated value. A small change only is made on the second iteration, in order that the sensitivity to changes in the estimated value of the obtained value can be measured on the next iteration.

After the second iteration the procedure for estimating the value of the feedback signal can evaluate that sensitivity, and can forecast the next estimated value based on that sensitivity in such a way that in a purely linear system the two values will coincide.

If, on the third iteration, it turns out that a linear estimate is not sufficiently accurate, a further algorithm is applied. This measures the present difference between the estimated value and the obtained value, and moves the estimated value by a small fraction of that difference (e.g. 1/8). If this fails the amount of movement is doubled on successive iterations. In the event of overshoot a small fraction of the last increment of the estimate is applied in the opposite direction. Essentially the algorithm applied is one of moving the estimate towards the obtained values in increasing jumps, until an overshoot occurs, in which case the search is taken back in the other direction with the jump size scaled down by a small fraction (for example, 1/8). The result (or consequence) is that searching for the correct estimated value is done to increasingly finer resolution. This is therefore inherently stable, and is flexible enough to permit several feedback signals to be modified at the same time.

In the case of analogue circuit blocks having a relatively complicated transfer function, the parameters of the cell may include the transfer function in the form of a Laplace transform or a Z-transform, and the program may be arranged to calculate the output signal value from the current input signal value and stored previous signal values taking into account the time scale.

## Claims

1. A method of simulating the operation of a circuit comprising at least a plurality of analog circuit blocks having operational parameters by means of a digital computer, said method comprising:
representing the circuit having a plurality of analog circuit blocks by a computer program;
in the computer program, representing each of said plurality of analog circuit blocks by a procedure call,
in the representation of each analog circuit block by a procedure call, including details of input signal names and values, and output signal names and values, the operational parameters of the analog block, and the sampling instant for evaluation of each output signal value,
representing each connection between the analog circuit blocks by the use of the same signal name for an output signal and an input signal,
providing real numbers to indicate the actual values of the input and output signals, and
establishing each sampling instant for the evaluation of an output signal value as the time at which that value has changed by a predetermined amount since the previous sampling instant, or an earlier time at which the value of another output signal of the same analog signal block has changed by the predetermined amount;
characterized by selecting a sampling time common to all of the procedure calls as the earliest of the sampling instants provided by the procedure calls of all of the analog circuit blocks included in the circuit whose operation is being simulated; and
evaluating the output signal values from the procedure calls -- representing each of said plurality of analog circuit blocks at the selected sampling time common to all of the procedure calls. --

2. A method as set forth in Claim 1, further characterized by modeling the operation of a circuit comprising digital circuit blocks by a logic simulator of event-driven type in a manner known per se so as to provide a model of a circuit includinq an analog sub-system and a digital sub-system;
representing the interconnections between the analog sub-system and the digital sub-system by an analog/digital interface; and
arranging the time scale of the digital sub-system to march the time scale of the analog sub-system. --

3. A method as set forth in Claim 1, further characterized by modeling the operation of a circuit comprising digital circuit blocks by a logic simulator of levelised compiled code type in a manner known per se so as to provide a model of a circuit including an analog sub-system and a digital sub-system;
representing the interconnections between the analog sub-system and the digital sub-system by an analog/digital interface; and
arranging the time scale of the digital sub-system to match the time scale of the analog sub-system. --

4. A method as set forth in either of Claims 2 or 3, further characterized by at least one one-bit digital-to-analog conversion in response to a digital logic value from the digital sub-system; and/or
at least one one-bit analog-to-digital conversion in response to an analog signal value from the analog sub-system. --

5. A method as set forth in any preceding claim, wherein the circuit comprising at least a plurality of analog circuit blocks includes a feedback path in which an input signal to part of the circuit is derived from an output signal of that part; and further characterized by:
progressively adjusting the fedback input signal conditioned upon previous adjustments of the fedback input signal while external input signals to the circuit are held constant; and
repeating the adjustments to the fedback input signal until a stable fedback input signal and a stable output signal are obtained. --

6. A method as set forth in Claim 5, further characterized by deriving an estimated value for the fedback input signal from the input signals applied to the circuit part before each of the progressive adjustments to the fedback input signal, and terminating the process of progressive adjustments to the fedback input signal when the difference between the value of the fedback input signal and the estimated value is less than a predetermined amount. --

7. A method as set forth in Claim 6, further characterized in that the predetermined amount is a predetermined fraction of a previous voltage step allocated to the circuit block. --

8. A method as set forth in either of Claims 6 or 7, further characterized by storing the values of the internal states of the part of the circuit to which the fedback input signal is applied in duplicate as a master copy and a working copy;
copying the working copy from the master copy at each adjustment of the fedback input signal;
employing the working copy in calculating the output signal value of the circuit part; and
updating the master copy at the common sampling times. --

9. A method as set forth in either of Claims 6 or 7, further characterized by deriving the estimated value for the fedback input signal from the input signals applied to the circuit part by a first manner of derivation wherein small changes in the input signals are caused to occur;
measuring the resulting changes in the fedback input signal;
calculating a sensitivity factor relating the resulting changes to the causal changes; and
deriving the estimated value for the fedback input signal from the input signals by employing the sensitvity factor on the assumption that the relationship is purely linear. --

10. A method as set forth in Claim 9, further characterized by monitoring the adjustments of the fedback input signal;
determining whether the condition for terminating the progressive adjustments to the fedback input signal may be satisfied within a few further additional adjustments; and
changing to a second manner of deriving the estimated value for the fedback input signal based upon the difference between the value of the fedback input signal and the previous estimated value when the condition for terminating the progressive adjustments to the fedback input signal is not satisfied within the few further additional adjustments. --

11. A method as set forth in Claim 10, further characterized in that the second manner of deriving the estimated value for the fedback input signal involves moving the estimated value toward the obtained value of the fedback input signal in increasing jumps until an overshoot occurs; and
reducing the jumps in response to the occurrence of an overshoot to a fraction of the previous size and performed in the opposite direction. --

12. A method as set forth in any preceding claim, further characterized in that the predetermined amount is 1% of the maximum possible variation in the output signal. --

## Patentansprüche

1. Verfahren zum Simulieren der Operation einer Schaltung, die wenigstens mehrere analoge Schaltungsblöcke mit Betriebsparametern enthält, mittels eines digitalen Computers, wobei das Verfahren enthält:
Darstellen der Schaltung mit mehreren analogen Schaltungsblöcken durch ein Computerprogramm;
Darstellen jedes der mehreren analogen Schaltungsblöcke durch einen Prozeduraufruf im Computerprogramm,
in der Darstellung jedes analogen Schaltungsblocks durch einen Prozeduraufruf, der Einzelheiten von Eingangssignalnamen und -werten und von Ausgangssignalnamen und -werten, die Betriebsparameter des analogen Blocks sowie den Abtastzeitpunkt für die Bewertung jedes Ausgangssignalwerts enthält,
Darstellen jeder Verbindung zwischen den analogen Schaltungsblöcken unter Verwendung des gleichen Signalnamens für ein Ausgangssignal und ein Eingangssignal,
Erzeugen von reellen Zahlen, um die tatsächlichen Werte der Eingangs- und Ausgangssignale anzugeben, und
Festlegen jedes Abtastzeitpunkts für die Bewertung eines Ausgangssignalwerts als den Zeitpunkt, zu dem sich der Wert um einen vorgegebenen Betrag seit dem vorhergehenden Abtastzeitpunkt geändert hat, oder als einen früheren Zeitpunkt, zu dem sich der Wert eines weiteren Ausgangssignals desselben analogen Signalblocks um den vorgegebenen Betrag geändert hat;
gekennzeichnet durch Auswählen eines Abtastzeitpunkts, der sämtlichen Prozeduraufrufen gemeinsam ist, als frühesten der Abtastzeitpunkte, die durch die Prozeduraufrufe sämtlicher analoger Schaltungsblöcke erzeugt werden, die in der Schaltung enthalten sind, deren Operation simuliert wird; und
Auswerten der Ausgangssignalwerte von den Prozeduraufrufen, die jeden der mehreren analogen Schaltungsblöcke zu dem ausgewählten Abtastzeitpunkt darstellen, welcher sämtlichen Prozeduraufrufen gemeinsam ist.

2. Verfahren nach Anspruch 1, ferner gekennzeichnet durch Nachbilden der Operation einer Schaltung, die digitale Schaltungsblöcke enthält, durch einen Logiksimulator des ereignisgesteuerten Typs in einer an sich bekannten Weise, um so ein Modell einer Schaltung zu erzeugen, die ein analoges Untersystem und ein digitales Untersystem enthält;
Darstellen der Zwischenverbindungen zwischen dem analogen Untersystem und dem digitalen Untersystem durch eine Analog/Digital-Schnittstelle; und
Anordnen der Zeitskala des digitalen Untersystems in der Weise, daß sie an die Zeitskala des analogen Untersystems angepaßt ist.

3. Verfahren nach Anspruch 1, ferner gekennzeichnet durch Nachbilden einer Operation einer Schaltung, die digitale Schaltungsblöcke enthält, mittels eines Logiksimulators des Typs mit nivelliertem, kompilierten Code in einer an sich bekannten Weise, um so ein Modell einer Schaltung zu erzeugen, das ein analoges Untersystem und ein digitales Untersystem enthält;
Darstellen der Zwischenverbindungen zwischen dem analogen Untersystem und dem digitalen Untersystem durch eine Analog/Digital-Schnittstelle; und
Anordnen der Zeitskala des digitalen Untersystems in der Weise, daß sie an die Zeitskala des analogen Untersystems angepaßt ist.

4. Verfahren nach irgendeinem der Ansprüche 2 oder 3, ferner gekennzeichnet durch wenigstens eine Einbit-Digital/Analog-Umsetzung als Antwort auf einen digitalen Logikwert vom digitalen Untersystem; und/oder
wenigstens eine Einbit-Analog/Digital-Umsetzung als Antwort auf einen analogen Signalwert vom analogen Untersystem.

5. Verfahren nach irgendeinem vorangehenden Anspruch, in dem die Schaltung, die wenigstens mehrere analoge Schaltungsblöcke umfaßt, einen Rückkopplungspfad enthält, in dem ein Eingangssignal an einen Teil der Schaltung aus einem Ausgangssignal dieses Teils abgeleitet wird; und ferner gekennzeichnet durch
progressives Einstellen des rückgekoppelten Eingangssignals, das durch vorhergehende Einstellungen des rückgekoppelten Eingangssignals konditioniert ist, während externe Eingangssignale in die Schaltung konstant gehalten werden; und
Wiederholen der Einstellungen für das rückgekoppelte Eingangssignal, bis ein stabiles rückgekoppeltes Eingangssignal und ein stabiles Ausgangssignal erhalten werden.

6. Verfahren nach Anspruch 5, ferner gekennzeichnet durch Ableiten eines geschätzten Werts für das rückgekoppelte Eingangssignal aus den in den Schaltungsteil eingegebenen Eingangssignalen vor jeder der progressiven Einstellungen für das rückgekoppelte Eingangssignal und Beenden des Prozesses der progressiven Einstellungen für das rückgekoppelte Eingangssignal, wenn die Differenz zwischen dem Wert des rückgekoppelten Eingangssignals und dem geschätzten Wert kleiner als ein vorgegebener Betrag ist.

7. Verfahren nach Anspruch 6, ferner dadurch gekennzeichnet, daß der vorgegebene Betrag ein vorgegebener Bruchteil einer früheren Spannungsstufe ist, die dem Schaltungsblock zugewiesen ist.

8. Verfahren nach einem der Ansprüche 6 oder 7, ferner gekennzeichnet durch Speichern der Werte der internen Zustände desjenigen Teils der Schaltung, in den das rückgekoppelte Eingangssignal eingegeben wird, in doppelter Weise als Hauptkopie und als Arbeitskopie;
Kopieren der Arbeitskopie von der Hauptkopie bei jeder Einstellung des rückgekoppelten Eingangssignals;
Verwenden der Arbeitskopie bei der Berechnung des Ausgangssignalwerts des Schaltungsteils; und
Aktualisieren der Hauptkopie zu den gemeinsamen Abtastzeitpunkten.

9. Verfahren nach irgendeinem der Ansprüche 6 oder 7, ferner gekennzeichnet durch Ableiten des geschätzten Werts für das rückgekoppelte Eingangssignal aus den in den Schaltungsteil eingegebenen Eingangssignalen in einer ersten Ableitungsweise, in der bewirkt wird, daß in den Eingangssignalen kleine Änderungen auftreten;
Messen der resultierenden Änderungen in dem rückgekoppelten Eingangssignal;
Berechnen eines Empfindlichkeitsfaktors, der auf die aus den bewirkten Änderungen resultierenden Änderungen bezogen ist; und
Ableiten des geschätzten Werts für das rückgekoppelte Eingangssignal aus den Eingangssignalen durch Verwenden des Empfindlichkeitsfaktors unter der Annahme, daß die Beziehung rein linear ist.

10. Verfahren nach Anspruch 9, ferner gekennzeichnet durch Überwachen der Einstellungen des rückgekoppelten Eingangssignals;
Bestimmen, ob die Bedingung zum Beenden der progressiven Einstellungen für das rückgekoppelte Eingangssignal innerhalb weniger weiterer zusätzlicher Einstellungen erfüllt werden kann; und
Ändern des geschätzten Wertes für das rückgekoppelte Eingangssignal in einer zweiten Ableitungsweise auf der Grundlage der Differenz zwischen dem Wert des rückgekoppelten Eingangssignals und dem vorherigen geschätzten Wert, wenn der Zustand zum Beenden der progressiven Einstellungen für das rückgekoppelte Eingangssignal nicht innerhalb der wenigen weiteren zusätzlichen Einstellungen erfüllt ist.

11. Verfahren nach Anspruch 10, ferner dadurch gekennzeichnet, daß die zweite Ableitungsweise des geschätzten Werts für das rückgekoppelte Eingangssignal das Bewegen des geschätzten Werts zum erhaltenen Wert des rückgekoppelten Eingangssignals in zunehmenden Sprüngen bis zum Auftreten eines Überschwingens umfaßt; und
die Sprünge als Antwort auf das Auftreten eines Überschwingens auf einen Bruchteil der vorhergehenden Größe reduziert und in entgegengesetzter Richtung ausgeführt werden.

12. Verfahren nach irgendeinem vorangegangenen Anspruch, ferner dadurch gekennzeichnet, daß der vorgegebene Betrag 1 % der höchstens möglichen Veränderung im Ausgangssignal ist.

## Revendications

1. Procédé de simulation du fonctionnement d'un circuit comprenant au moins une pluralité de blocs de circuits analogiques ayant des paramètres opérationnels, au moyen d'un calculateur numérique, le procédé comprenant les étapes consistant à :
représenter le circuit ayant une pluralité de blocs de circuits analogiques par un programme d'ordinateur ;
dans le programme d'ordinateur, représenter chaque bloc de ladite pluralité de blocs de circuits analogiques par un appel de procédure,
dans la représentation de chaque bloc de circuit analogique par un appel de procédure, inclure des détails de noms et de valeurs de signal d'entrée, et de noms et de valeurs de signal de sortie, les paramètres opérationnels du bloc analogique, et les instants d'échantillonnage pour l'évaluation de chaque valeur de signal de sortie,
représenter chaque connexion entre les blocs de circuits analogiques à l'aide d'un même nom de signal pour un signal de sortie et un signal d'entrée,
fournir des nombres réels pour indiquer les valeurs actuelles des signaux d'entrée et de sortie, et
établir chaque instant d'échantillonnage pour l'évaluation d'une valeur de signal de sortie à l'instant auquel cette valeur a été modifiée par une quantité prédéterminée depuis l'instant d'échantillonnage précédent, ou à un instant précédent auquel la valeur d'un autre signal de sortie du même bloc de signal analogique a été modifiée par la quantité prédéterminée ;
caractérisé en ce que l'on sélectionne un instant d'échantillonnage commun pour tous les appels de procédure comme étant le plus précoce des instants d'échantillonnage fournis par les appels de procédure de tous les blocs de circuits analogiques inclus dans le circuit dont le fonctionnement est simulé ; et
on évalue les valeurs de signal de sortie à partir des appels de procédure représentant chacun de ladite pluralité de blocs de circuits analogiques à l'instant d'échantillonnage sélectionné et commun à tous les appels de procédure.

2. Procédé selon la revendication 1, caractérisé en ce que l'on modélise en outre le fonctionnement d'un circuit comprenant des blocs de circuits numériques par un simulateur logique du type piloté par événement d'une façon connue en elle-même de manière à fournir un modèle d'un circuit comportant un sous-système analogique et un sous-système numérique ;
l'on représente les interconnexions entre le sous-système analogique et le sous-système numérique par une interface analogique/numérique ; et
l'on arrange l'échelle de temps du sous-système numérique pour l'adapter à l'échelle de temps du sous-système analogique.

3. Procédé selon la revendication 1, caractérisé en ce que l'on modélise en outre le fonctionnement d'un circuit comportant des blocs de circuits numériques par un simulateur logique du type à code compilé hiérarchisé de façon connue en elle-même de façon à fournir un modèle d'un circuit comportant un sous-système analogique et un sous-système numérique ;
l'on représente les interconnexions entre le sous-système analogique et le sous-système numérique par une interface analogique/numérique ; et
l'on arrange l'échelle de temps du sous-système numérique pour la faire correspondre à l'échelle de temps du sous-système analogique.

4. Procédé selon l'une des revendications 2 et 3, caractérisé en ce qu'il comporte en outre au moins une conversion numérique-analogique, bit à bit en réponse à une valeur logique numérique provenant du sous-système numérique ; et/ou
au moins une conversion analogique-numérique bit à bit en réponse à une valeur de signal analogique provenant du sous-système analogique.

5. Procédé selon l'une quelconque des revendications précédentes, dans lequel le circuit comprenant au moins une pluralité de blocs de circuits analogiques comporte un trajet de contre-réaction dans lequel un signal d'entrée d'une partie du circuit est déduite d'un signal de sortie de cette partie, caractérisé en ce que l'on ajuste de façon progressive le signal d'entrée de la contre-réaction conditionné lors des ajustements précédents du signal d'entrée de contre-réaction tandis que les signaux d'entrée externes du circuit sont maintenus constants ; et
l'on répète les ajustements du signal d'entrée de contre-réaction jusqu'à un signal d'entrée de contre-réaction stable et un signal de sortie stable soient obtenus.

6. Procédé selon la revendication 5, caractérisé en ce que l'on déduit en outre une valeur estimée pour le signal d'entrée de contre-réaction à partir des signaux d'entrée appliqués à la partie de circuit avant chacun des ajustements progressifs du signal d'entrée de contre-réaction, et l'on achève le procédé d'ajustement progressif du signal d'entrée de contre-réaction lorsque la différence entre la valeur du signal d'entrée de contre-réaction et la valeur estimée est inférieure à une quantité prédéterminée.

7. Procédé selon la revendication 6, caractérisé en ce que la quantité prédéterminée est une fraction prédéterminée d'un échelon de tension précédant alloué au bloc de circuit.

8. Procédé selon l'une des revendications 6 et 7, caractérisé en ce que l'on stocke les valeurs des états internes de la partie du circuit à laquelle le signal d'entrée de contre-réaction est appliqué de façon dupliquée sous la forme d'une copie maître et d'une copie de travail ;
l'on copie la copie de travail à partir de la copie maître à chaque ajustement du signal d'entrée de contre-réaction ;
l'on utilise la copie de travail pour calculer la valeur de sortie de la partie de circuit ; et
l'on met à jour la copie maître aux instants d'échantillonnage communs.

9. Procédé selon l'une des revendications 6 et 7, caractérisé en ce que l'on déduit la valeur estimée du signal d'entrée de contre-réaction à partir des signaux d'entrée appliqués à la partie de circuit par une première façon de déduction dans laquelle des petites variations dans les signaux d'entrée sont provoquées ;
l'on mesure les modifications résultantes dans le signal d'entrée de contre-réaction ;
l'on calcule un facteur de sensibilité reliant les modifications résultantes et les modifications provoquées ; et
l'on déduit la valeur estimée du signal d'entrée de contre-réaction provenant des signaux d'entrée en utilisant le facteur de sensibilité en supposant que cette relation est purement linéaire.

10. Procédé selon la revendication 9, caractérisé en ce que l'on surveille les ajustements du signal d'entrée de contre-réaction ;
l'on détermine si les conditions pour achever les ajustements progressifs du signal d'entrée de contre-réaction peuvent être satisfaites à l'aide de quelques ajustements additionnels successifs ; et
l'on modifie selon une deuxième façon de déduction de la valeur estimée du signal d'entrée de contre-réaction en se basant sur la différence entre la valeur du signal d'entrée de contre-réaction et la valeur estimée précédemment lorsque la condition pour achever les ajustements progressifs du signal d'entrée de contre-réaction n'est pas satisfaite à l'aide de quelques ajustements additionnels successifs.

11. Procédé selon la revendication 10, caractérisé en ce que la seconde façon de déduction de la valeur estimée du signal d'entrée de contre-réaction implique le déplacement de la valeur estimée en direction de la valeur obtenue du signal d'entrée de contre-réaction à l'aide de sauts d'incrémentation jusqu'à ce qu'un dépassement se produise ; et
l'on réduit les sauts en réponse à l'apparition d'un dépassement jusqu'à une fraction de la dimension précédente, réalisé dans la direction opposée.

12. Procédé selon l'une quelconque des revendications précédentes, caractérisé en ce que ladite quantité prédéterminée est égale à 1% de la variation possible maximale du signal de sortie.
